# EUROPEAN PATENT APPLICATION

(11) **EP 2 644 681 A2**
(43) Date of publication of application: **02.10.2013**
(21) Application number: 13160922.4
(22) Date of filing: 25.03.2013
(51) Int. Cl.: C09K 11/77

(54) **Wavelength Converting Member, Making Method, and Light-Emitting Device**

(30) Priority: 27.03.2012 JP 2012071100
(71) Applicant: Shin-Etsu Chemical Co., Ltd., Chiyoda-ku, Tokyo (JP)
(72) Inventor: Tsumori, Toshihiro, Echizen-shi, Fukui-ken, (JP); Wataya, Kazuhiro, Echizen-shi, Fukui-ken, (JP)
(74) Representative: Thurston, Joanna

(57) **Abstract**

A wavelength converting member is prepared by coating the surface of a polycrystalline transparent ceramic substrate with an activator and firing the activator-coated ceramic substrate for letting the activator diffuse into the ceramic substrate from its surface.

## Description

### TECHNICAL FIELD

This invention relates to a wavelength converting member for use with a light source for wavelength converting a portion of light from the light source while transmitting another portion of light, a light-emitting device using the member, and a method for preparing the member.

### BACKGROUND ART

Light-emitting diodes are among the most efficient light sources currently available. Recently active efforts are made to develop white light emitting devices by combining blue LED with phosphors. For example, JP-A 2007-150331 discloses a wavelength converting member comprising garnet or the like, specifically a light-transmissive, homogeneous wavelength converting member capable of wavelength converting light emitted by a light emitting component, and a light-emitting device comprising the wavelength converting member. The wavelength converting member is expected to have higher heat resistance and higher mechanical strength than the prior art wavelength converting layer comprising a phosphor and a resin in which the phosphor is dispersed, and is also expected to have high durability against the heat that increases as the output of light emitting components increases.

One known method of manufacturing such a wavelength converting member is by formulating a raw material having the same composition of constituent elements as the wavelength converting member, shaping, machining, and sintering at high temperature.

### Citation List

Patent Document 1: JP-A 2007-150331 (US 7514721, EP 1958269)

### SUMMARY OF INVENTION

An object of the invention is to provide a method for manufacturing a wavelength converting member in a different way from the prior art method, the resulting wavelength converting member, and a light-emitting device using the member.

According to the invention, a member for wavelength conversion of light emitted by a light source (i.e., wavelength converter) is manufactured by previously preparing a light-transmissive substrate having the same composition as the final member except an activator, coating the surface of the substrate with the activator, and holding the substrate in a hot atmosphere to allow the activator to diffuse into the substrate (letting the activator diffuse into the substrate).

The substrate or matrix of which the wavelength converting member is constructed may be light-transmissive alumina, light-transmissive yttrium aluminum garnet (YAG), light-transmissive lutetium aluminum garnet or the like. Such substrates are relatively readily available. While oxides of Tb, Eu and Ce are generally used as the activator for turning these materials into fluorescent materials, they are also relatively readily available. However, wavelength converting members having a certain content of activator are not readily available.

The inventors have found that a wavelength converting member can be manufactured by starting with a relatively readily available transparent ceramic substrate, coating it with an activator, and letting the activator diffuse at high temperature.

In one aspect, the invention provides a method for preparing a wavelength converting member, comprising the steps of:
coating the surface of a polycrystalline light-transmissive ceramic substrate with an activator, and
firing the activator-coated ceramic substrate for letting the activator diffuse into the ceramic substrate from the surface.

Typically, the polycrystalline transparent ceramic substrate has the composition of Y₃Al₅O₁₂, Lu₃Al₅O₁₂, (Y,Lu)₃Al₅O₁₂, (Y,Gd)₃AlSO₁₂, or Al₂O₃. Also typically, the activator is an oxide of cerium, europium or terbium.

Preferably, the firing step is at a temperature of 1,000 to 1,800° C.

In another aspect, the invention provides a wavelength converting member comprising a polycrystalline light-transmissive ceramic substrate in which an activator has been diffused from its surface, the ceramic substrate being constructed of polycrystalline grains, and the activator being distributed in a higher concentration near grain boundaries than at the center of grains.

In a preferred embodiment, the activator around each grain has such a concentration distribution that the concentration decreases from the grain boundary toward the grain center.

In a further preferred embodiment, the activator within the ceramic substrate has such a concentration distribution in thickness direction that the concentration gradually decreases from the surface of the substrate to depth.

Typically, the polycrystalline transparent ceramic substrate has the composition of Y₃Al₅O₁₂, Lu₃Al₅O₁₂, (Y,Lu)₃Al₅O₁₂, (Y,Gd)₃Al₅O₁₂, or Al₂O₃. Also typically, the activator is an oxide of cerium, europium or terbium.

Also contemplated herein is a light-emitting device comprising the wavelength converting member defined above.

### ADVANTAGEOUS EFFECTS OF INVENTION

According to the invention, a wavelength converting member having an arbitrary activator added thereto can be manufactured using a transparent ceramic substrate which is relatively readily available.

### BRIEF DESCRIPTION OF DRAWINGS

FIG. 1 is a photomicrograph in cross section of the light-transmissive YAG ceramic plate following the diffusion treatment of activator (ceria).
FIG. 2 illustrates the distribution of elements near the surface following the diffusion treatment.

### DESCRIPTION OF PREFERRED EMBODIMENTS

The transparent ceramic substrate used herein is preferably selected from among Y₃Al₅O₁₂, Lu₃Al₅O₁₂, (Y,Lu)₃Al₅O₁₂, (Y,Gd)₃Al₅O₁₂, and Al₂O₃. These transparent ceramics are relatively readily available since they are widely used as optical and structural materials besides the wavelength converter application contemplated herein. With the prior art method, when these materials are used as the substrate for wavelength converting members, a transparent ceramic substrate of specific size in which the type and concentration of activator are limited is prepared to comply with a particular application. An attempt to produce the desired emission characteristics from the wavelength converting member prepared by this method fails even if the size and activator concentration slightly deviate from the specified values. It is thus necessary to strictly control the concentration of activator and the size of wavelength converting member.

Insofar as members for wavelength conversion of part or the entirety of visible or ultraviolet light as in the case of white LED are concerned, it is desirable to produce a member having a different concentration of activator. To this end, a mixed raw material having a certain concentration of activator must be formulated prior to shaping and sintering. To meet such requirement, a number of raw materials having a varying concentration of activator must be provided. To obtain the desired characteristics from this wavelength converting member, the wavelength converting member must be worked to a specific size by the precision machining technology. To obviate these difficulties of manufacture, it would be desirable if the amount of activator in transparent ceramic can be controlled independent of the substrate type and the machining size. The invention provides a manufacture method which is superior to the prior art method in this respect.

Since the transparent ceramic materials such as Y₃Al₅O₁₂, Lu₃Al₅O₁₂, (Y,Lu)₃Al₅O₁₂, (Y,Gd)₃Al₅O₁₂ and Al₂O₃ have a fixed composition, it is relatively easy to prepare substrates of single size therefrom. With respect to the preparation of these ceramic materials, for example, JP 2866891 describes in detail the preparation of Y₃Al₅O₁₂ ceramic material. According to our invention, an activator is introduced into such a transparent ceramic material by coating the surface of a ceramic substrate with an activator and letting the activator diffuse into the ceramic substrate. The transparent ceramic substrate used herein must be constructed of polycrystalline grains. This is because the activator diffuses into the interior along grain boundaries and further into crystal grains. If the ceramic substrate is monocrystalline, the activator cannot be introduced into the ceramic substrate in a sufficient amount to exert a wavelength converter function. The desired means of diffusing the activator into the transparent ceramic substrate is by annealing the ceramic substrate surface-coated with activator at a high temperature.

The activator used herein is typically selected from among rare earth elements and/or rare earth oxides thereof, especially oxides of cerium, europium and terbium.

The activator, when applied to the ceramic substrate, may be in any form of oxide particle, metal foil, vapor deposited oxide, inorganic salt, organic salt, complex or the like as long as a uniform coating can be formed on the ceramic substrate. One preferred coating procedure is by dispersing particles of oxide or the like in a solvent such as water or alcohol, applying the dispersion to the ceramic substrate, and removing the solvent via volatilization or the like. Alternatively, the activator may be deposited or applied to the ceramic substrate by sputtering or vacuum evaporation.

The coating weight as the activator is preferably in a range of 3×10⁻⁶ mol/cm² to 3×10⁻⁵ mol/cm². If the coating weight is less than 3×10⁻⁶ mol/cm², the amount of activator available for diffusion is too small to provide the desired performance as the light-emissive ceramic material. If the coating weight exceeds 3×10⁻⁵ mol/cm², sintering of the activator alone on the surface or reaction of the activator with the substrate near the surface can occur during high-temperature firing to create a composite which inhibits the activator from diffusing into the substrate, failing to achieve effective activator diffusion.

As the coating weight of the activator is varied in the above range, fluorescent efficiency of the ceramic can be controlled even when irradiated with identical blue LED. For example, assuming that light converting members are produced by uniformly coating light-transmissive YAG with cerium oxide and then annealing, the light converting member resulting from a less coating weight of cerium oxide offers a less proportion of conversion to yellow light upon irradiation with blue LED, and hence light emission having a high color temperature. As the coating weight of cerium oxide is increased, the light emission turns to be of warm color as a whole. According to the invention, the emission color of the wavelength converting member can be changed by varying the coating weight of the activator. This advantageously eliminates a need for precision machining of the wavelength converting member.

The activator coated to the ceramic substrate may be dried, calcined at or below 800°C, or otherwise treated after coating, depending on the form of activator.

The transparent ceramic substrate coated with the activator is then heated at a high temperature for letting the activator diffuse into the ceramic substrate from its surface. Although the firing temperature suitable for activator diffusion varies with the type of both ceramic and activator, the firing temperature is preferably in a range of 1,000 to 1,800°C, more preferably 1,500 to 1,700°C, and even more preferably 1,600 to 1,700°C. A temperature below 1,000°C may be insufficient to let the activator diffuse into the ceramic substrate whereas a temperature in excess of 1,800°C may cause deformation of the ceramic substrate itself. In either case, difficulty may arise in obtaining satisfactory wavelength converting members. The firing atmosphere may be air, reducing or vacuum atmosphere although the choice depends on the type of activator. Firing may be followed by heat treatment at a high temperature again. The firing time is typically 1 to 24 hours, preferably 3 to 15 hours, and more preferably 5 to 12 hours.

Diffusion of the activator into the transparent ceramic substrate first takes place along grain boundaries in the ceramic substrate. Thereafter, the activator further diffuses from the grain boundary to the grain interior. Since the activator diffuses along grain boundaries in the ceramic substrate, the concentration near the grain boundary is higher than at the grain center. Also, the activator around each grain has such a concentration distribution that the concentration may decrease from the grain boundary toward the grain center.

The depth of diffusion of the activator is generally in a range of 50 to 600 µm although it depends on the type of ceramic, the size of crystal grains, the type of activator, firing temperature, and firing time. In the ceramic substrate, the activator has such a concentration distribution in thickness direction that the concentration may gradually decrease from the surface of the substrate to depth.

The transparent ceramic substrate having the activator diffused therein may be ground on the activator-coated surface for the purpose of removing the undiffused activator, or roughened by sand blasting or the like for the purpose of increasing asperities for improving light diffusion or transmittance.

The wavelength converting member thus manufactured has high transparency and fluorescent efficiency.

The ceramic substrate as annealed has a flat and smooth surface. On cross-sectional observation by BEI, a region where the activator diffused along the grain boundary in the substrate was confirmed across a limited narrow range from the surface. The thickness of this activator diffusion region and the activator diffusion state were uniform at every area on the ceramic substrate surface. Fluorescence by exciting light from blue LED was confirmed.

### EXAMPLE

Examples of the invention are given below by way of illustration and not by way of limitation.

### Example 1

Cerium oxide particles having an average particle size of 200 nm, 1 g, was admitted into 20 g of an acrylic emulsion (Vinyzol 1020 by Daido Chemical Corp.), which was ultrasonified at 35 kHz for 30 minutes, obtaining a ceria dispersion.

A light-transmissive YAG ceramic plate of 50.8 × 50.8 × 1 mm having a purity of 99.99% and a linear transmittance of 75% at wavelength 450 nm was prepared as a substrate. The ceria dispersion was spray coated onto the substrate surface and dried in an oven at 120°C to form a ceria coating on the substrate surface. The weight of the coated substrate was measured, finding a weight gain of 81.3 mg, which corresponded to a coating weight of ceria per surface area of 3.15 mg/cm². The coated substrate was calcined in air at 600°C and fired in a mixed gas atmosphere of 98% Ar and 2% hydrogen at 1,650°C for 5 hours, completing a wavelength converting member.

A cross section of the wavelength converting member as fired was observed under SEM, finding that cerium had diffused along grain boundaries. The diffusion distance was about 100 µm from the surface to depth.

When irradiated with light of wavelength 450 nm, the wavelength converting member emitted light having a peak at wavelength -552 nm.

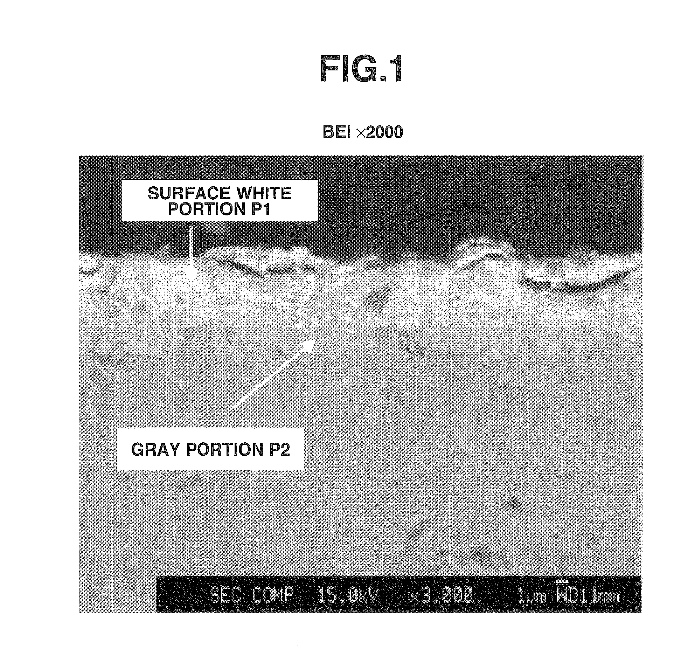

FIG. 1 illustrates a cross section of the light-transmissive YAG ceramic plate following the diffusion treatment of activator (ceria) as observed under SEM (BEIx2000). Table 1 shows semi-quantitative determination values of surface white portion P1 and gray portion P2 in FIG. 1 and the YAG ceramic (sintered body).

**Table 1**

| Semi-quantitative determination values (wt%) | | | | | |
|---|---|---|---|---|---|
| | Y | A1 | Ce | O | Total |
| P1 | 14.3 | 14.8 | 52.0 | 27.1 | 108.2 |
| P2 | 45.8 | 18.6 | 9.0 | 31.1 | 104.5 |
| Sintered YAG | 39.5 | 25.2 | - | 31.1 | 95.8 |

It is noted that unlike quantitative analysis, semi-quantitative analysis involves quantitative correction from spectral data. Specifically, the semi-quantitative determination value is obtained by identifying an element by qualitative analysis software, determining a peak background intensity from the qualitative spectrum based on the identified element, computing a ratio of the intensity to the characteristic X-ray intensity of pure element, and making corrections therefrom.

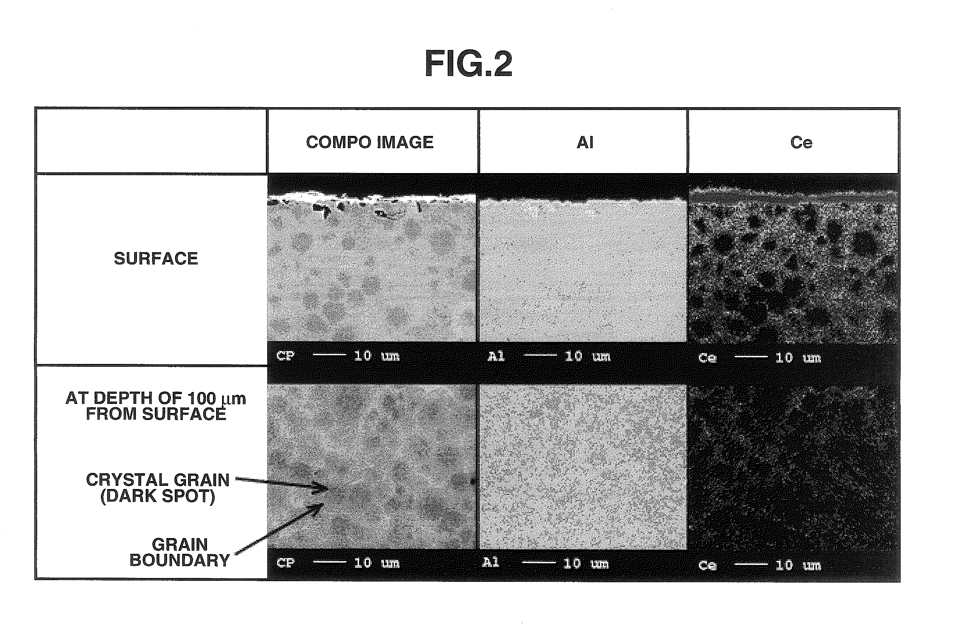

FIG. 2 illustrates the distribution of elements near the surface following the diffusion treatment.

### Example 2

Using a magnetron sputtering system, cerium oxide particles were coated on the surface of a light-transmissive YAG ceramic plate of 1 mm thick having a purity of 99.99% and a linear transmittance of 75% at wavelength 450 nm. A cross section of the plate was observed under SEM, finding that a ceria coating of 15 µm was formed on the surface. The ceria-coated YAG ceramic plate was fired in a mixed gas atmosphere of 98% Ar and 2% hydrogen at 1,650°C for 5 hours. The ceria-coated surface of the ceramic plate as fired was buffed with colloidal silica, completing a wavelength converting member.

A cross section of the wavelength converting member was observed under SEM, finding that cerium had diffused along grain boundaries over the entire surface as in Example 1. When irradiated with light of wavelength 450 nm, the wavelength converting member emitted light having a peak at wavelength ∼552 nm.

### Comparative Example 1

Cerium oxide particles having an average particle size of 200 nm, 1 g, was immersed in 20 g of deionized water and an acrylic emulsion (Vinyzol 1020 by Daido Chemical Corp.), which was ultrasonified at 35 kHz for 30 minutes, obtaining a ceria dispersion.

A light-transmissive YAG ceramic plate of 50.8 × 50.8 × 1 mm having a purity of 99.99% and a linear transmittance of 75% at wavelength 450 nm was prepared as a substrate. The ceria dispersion was spray coated onto the substrate surface and dried in an oven at 120°C to form a ceria coating on the substrate surface. The weight of the coated substrate was measured, finding a weight gain of 105 mg, which corresponded to a coating weight of ceria per surface area of 4.01 mg/cm². The resulting member produced no fluorescence when irradiated with light of wavelength 450 nm.

## Claims

1. A method for preparing a wavelength converting member, comprising the steps of:
coating the surface of a polycrystalline transparent ceramic substrate with an activator, and
firing the activator-coated ceramic substrate letting the activator diffuse into the ceramic substrate from the surface.

2. The method of claim 1 wherein the polycrystalline transparent ceramic substrate has the composition of Y₃Al₅O₁₂, Lu₃Al₅O₁₂, (Y,Lu)₃Al₅O₁₂, (Y,Gd)₃Al₅O₁₂, or Al₂O₃.

3. The method of claim 1 or 2 wherein the activator is an oxide of cerium, europium or terbium.

4. The method of any one of claims 1 to 3 wherein the firing step is at a temperature of 1,000 to 1,800°C.

5. A wavelength converting member comprising a polycrystalline transparent ceramic substrate in which an activator has been diffused from its surface, the ceramic substrate being constructed of polycrystalline grains, and the activator being distributed in a higher concentration near grain boundaries than at the center of grains.

6. The wavelength converting member of claim 5 wherein the activator around each grain has such a concentration distribution that the concentration decreases from the grain boundary toward the grain center.

7. The wavelength converting member of claim 5 or 6 wherein the activator within the ceramic substrate has such a concentration distribution in thickness direction that the concentration gradually decreases from the surface of the substrate to depth.

8. The wavelength converting member of any one of claims 5 to 7 wherein the polycrystalline transparent ceramic substrate has the composition of Y₃Al₅O₁₂, Lu₃Al₅O₁₂, (Y,Lu)₃Al₅O₁₂, (Y,Gd)₃Al₅O₁₂, or Al₂O₃.

9. The wavelength converting member of any one of claims 5 to 8 wherein the activator is an oxide of cerium, europium or terbium.

10. A light-emitting device comprising the wavelength converting member of any one of claims 5 to 9.
